# EUROPEAN PATENT APPLICATION

(11) **EP 0 924 527 A1**
(43) Date of publication of application: **23.06.1999**
(21) Application number: 97830678.5
(22) Date of filing: 16.12.1997
(51) Int. Cl.: G01R 31/28

(54) **Wafer probe station with impression of ultrasonic vibrations on probe contacts**

(71) Applicant: STMicroelectronics S.r.l., 20041 Agrate Brianza MI (IT)
(72) Inventor: Ferradino, Enzo, 20127 Milano (IT); Orsi, Carlo, 20041 Agrate Brianza (IT)
(74) Representative: Pellegri, Alberto

(57) **Abstract**

A test-on-wafer station employs ultrasounds for enhancing establishment of electric contact between a plurality of conducting probes and the respective pads before carrying out electrical testing of the integrated circuit. Ultrasounds have preferably a frequency not greater than 40 kHz and are applied for no longer than 10 ms.

## Description

The present invention relates to a station of "test-on-wafer" of semiconductor devices.

Test stations for carrying out quality control testing on wafers of integrated semiconductor devices being fabricated are installations of basic importance for controlling the quality of microelectronics productions. These test stations are rather complex as they are equipped with sophisticated apparatuses for the automation of the testing operations in order to permit high levels of productivity in performing quality control tests on all the pieces being fabricated.

Commonly, each test station has an inventory of interchangeable EWS probe cards and an inventory of interchangeable test cards. Basically, each card is specifically constructed for testing a specific product. In particular an EWS probe card is the means by which a plurality of minute conducting probes are placed in contact with respective metal pads formed on the front surface of each integrated device being fabricated on the wafer.

The electric contact between the tip of each probe and the respective contact pad is established by elastic force and it is evident that the uniformity and reproducibility of the contact pressure are critical factors for the regularity and precision of the measurements of the electrical parameters which must be carried out on the single integrated device being tested.

Conversely, a test card is a card which contains appropriate circuitry for implementing predetermined biasing conditions and detecting functions of electrical parameters through the plurality of contacting probes, as well as control, compensation, and data processing functions in order to present the results of the tests in a most appropriate form to a variety of analytical equipment which determine whether the tested device fits the design specifications.

Test-on-wafer stations, besides having a frame for coordinately supporting the EWS probe card and the test card disposed above it, is equipped with robots capable of picking up one by one in succession the wafers to be tested by means of special suction pick-up heads. The robots place a wafer below the probe card, align it with great accuracy with the probe card, and to lift the wafer against the plurality of conducting pointed probes supported at the ends of as many flexible conducting arms to establish the necessary electric contacts with the respective metal pads of the distinct integrated devices being fabricated on the wafer.

Once all the contacts are established, an electric test cycle takes place.

At the end of each testing cycle the robots provide to lower the head that holds the wafer away from the plurality of probes and to unload it, while a new wafer is aligned and brought in contact with the plurality of pointed probes.

The establishment of a reliable electric contact between each one of the large number of pads and the relative probe is often made difficult by the presence of oxide films or other substances over the surface of the pads or over some of them. This often leads lead to unreliable test results despite of the perfect functioning of the integrated circuit being tested.

To ensure a satisfactory contact it is often used a technique referred to as *"overdrive"* that is, once the pointed probes are in contact with the pads surfaces, a further lifting of the chuck by approximately 100-200 µm is effected so that the points may better *"cut"* into the pads. Of course, this produces a scar on the pad surface of a length proportional to the predetermined overdrive. The drawbacks of this technique are twofold:
I. the scar should not reach the edge of the pad, thus the overdrive must be of a limited maximum value.
II. the pads must be rather wide to permit a significant overdrive.

Confronted with these difficulties it has now been found a more effective way of overcoming the problem of a likely presence of an oxide film or other substances on the surface of the contact pads that may impede to one or more probes to establish an effective ohmic contact with the metal film of the respective pad, despite of the elastic pressure exerted through the flexible arms that support the probe.

It has now been found that by applying ultrasound vibrations of a frequency band adjacently near the acoustic band, typically of frequencies not greater than 40 kHz, during a contacting phase, the eventuality of a missing ohmic contact through one or more probes with the respective wafer pads may be practically eliminated.

The application of vibrational energy in the form of ultrasound during a contact establishing phase or more precisely during the initial phase of contacting for a duration of few milliseconds and up to 10 milliseconds while maintaining contacting a constant load, is very effective in promoting the establishment of an ohmic contact between the pointed probe and the metal pad, even in the presence of resistive or dielectric films.

The application of ultrasound vibrational energy for few milliseconds is carried out by coupling to the supporting body of the wafer holding, head of the robot of the test station robot, an ultrasound transducer driven electronically by a dedicated circuitry, or even by coupling the transducer to the probe card.

The coupling may be established on a specially arranged surface of the supporting chuck of the wafer by fastening the transducer thereto by the use of screws or similar fasteners, according to normal coupling techniques.

Transducers that may be satisfactorily employed for this purpose, even in terms of deliverable rated power, may be any of the ultrasound transducers that are commonly used for welding the connecting wires on the devices pads in assembling the simple devices.

Some examples of commercially available ultrasound transducers that can be used are:
- ASM AB305 mod 238: (30W 10mA)
- KS 1488 PLUS KS#01482-1045-800-04 (30W 10mA)
obviously equipped with their relative control and supply circuitry.

The elasticity of the cantilever conducting flexible arms that support the pointed probes provide for an adequate absorption and dissipation of the ultrasound energy thus averting an excessive overheating of the contact point.

On the other hand, the vibratory motion point of contact on the pad surface between the tip of the cantilevered pointed probe at the end of its flexible arm and the surface of the respective pad produce mutual microshifts that are effective in removing and in causing a local encroaching of the tip through the oxide film which may exist over the metal pad, ensuring an outstandingly reliable ohmic contact between the probe and the metal layer.

In practice, the application of ultrasound energy permits to greatly reduce the length of the scarring even when imposing a certain overdrive.

This in turns permits to reduce by 10%-15% the linear dimensions of the pads, thus increasing the proportion of silicon area available for integrating the active circuit.

## Claims

1. A test-on-wafer station comprising a framework supporting at least a probe card equipped with a plurality of conducting pointed probes at the ends of respective cantilevered flexible arms, establishing electric contacts with respective pads of the wafer by an elastic contact pressure exercised upon lifting against the plurality of pointed probes a wafer held by a check of a pick-up transfer and unload robot, characterized in that it comprises
at least a transducer-generator of ultrasound coupled to a supporting body of said chuck, producing ultrasound vibrations of a frequency not greater than 40 kHz during a first phase of the contacting of a wafer with said plurality of probes.

2. The station according to claim 1, in which application of ultrasounds is effected for a duration of no more than 10 ms.

3. The station according to claim 2, characterized in that said transducer-generator of ultrasounds delivers a power ranging between 1 and 30 W.
